Europäisches Patentamt

European Patent Office

Office européen des brevets

(11) Veröffentlichungsnummer: **0 257 504 B1**

(12) **EUROPÄISCHE PATENTSCHRIFT**

(45) Veröffentlichungstag der Patentschrift: **23.12.92**

(21) Anmeldenummer: **87111879.0**

(22) Anmeldetag: **17.08.87**

(51) Int. Cl.⁵: **G03F 7/075**

(54) **Vorsensibilisierte Druckplatte und Verfahren zur Herstellung einer Druckform für den wasserlosen Flachdruck.**

(30) Priorität: **23.08.86 DE 3628719**

(43) Veröffentlichungstag der Anmeldung:
**02.03.88 Patentblatt 88/09**

(45) Bekanntmachung des Hinweises auf die Patenterteilung:
**23.12.92 Patentblatt 92/52**

(84) Benannte Vertragsstaaten:
**DE FR GB**

(56) Entgegenhaltungen:

**CHEMICAL ABSTRACTS, Band 93, Nr. 12, Dezember 1980, Zusammenfassung Nr. 228624n, Columbus, Ohio, US & SU-A-742 859 (LENINGRAD TECHNOLOGICAL INSTITUTE) 25-06-1980**

**CHEMICAL ABSTRACTS, Band 100, Nr. 20, 14. Mai 1984, Seite 568, Zusammenfassung Nr. 165457a, Columbus, Ohio, US & JP-A-58 24 149 (FUJI PHOTO FILM CO.) 14-02-1983**

(73) Patentinhaber: **HOECHST AKTIENGESELL-SCHAFT**
**Postfach 80 03 20**
**W-6230 Frankfurt am Main 80(DE)**

(72) Erfinder: **Herrmann, Heinz, Dr.**
**Am Güldenplan 15**
**W-6200 Wiesbaden(DE)**
Erfinder: **Schlosser, Hans-Joachim, Dr.**
**Am Rosengarten 2a**
**W-6200 Wiesbaden(DE)**

**Beschreibung**

Die Erfindung betrifft eine vorsensibilisierte Druckplatte für den wasserlosen Flachdruck, insbesondere Offsetdruck, sowie ein Verfahren zur Herstellung einer Druckform durch Belichten und Entwickeln dieser Druckplatte. Die erfindungsgemäße Druckplatte weist einen Schichtträger, eine strahlungsempfindliche Schicht und eine äußere, Druckfarbe abweisende Schicht aus Silikongummi auf.

Druckplatten dieses Schichtaufbaus mit positiv und negativ arbeitenden strahlungsempfindlichen, insbesondere lichtempfindlichen Schichten sind z. B. aus der US-A 3 511 178 bekannt. Als negativ arbeitende, d. h. lichthärtbare lichtempfindliche Verbindungen werden Diazoniumsalz-Kondensationsprodukte eingesetzt. Die belichtete Druckplatte wird mit einer Lösung entwickelt, die die unbelichteten Bereiche der lichtempfindlichen Schicht lösen und die Silikongummischicht anquellen. Dabei lassen sich die über den löslichen Schichtbereichen liegenden Silikongummibereiche durch Reiben entfernen. Die erhaltene Druckform nimmt an den freigelegten Bereichen des Schichtträgers Druckfarbe an, während die an den unbelichteten Stellen stehengebliebene Silikongummischicht Druckfarbe abweist. Sie druckt also ein Negativ der verwendeten Belichtungsvorlage. Als positiv arbeitende Verbindungen werden unlösliche Fällungsprodukte von Diazoniumsalzen und Phosphorwolframsäure eingesetzt. In diesem Fall wird zur Verankerung der Silikongummischicht auf der lichtempfindlichen Schicht eine Zwischenschicht aus einem Diazoniumsalz-Formaldehydkondensat zwischen diesen Schichten vorgesehen. Diese Zwischenschicht wird beim Aushärten der Silikonkautschukschicht zur Silikongummischicht durch Erwärmen vernetzt und bewirkt dann die gewünschte verbesserte Haftung.

Es sind auch wasserlos druckende Flachdruckplatten mit anderen lichtempfindlichen Schichten bekannt. In den meisten Fällen ist eine entsprechende Haftschicht erforderlich und beschrieben.

Gemäß der DE-A 29 43 379 wird eine lichtempfindliche Schicht aus o-Chinondiazid und Novolak eingesetzt, auf die eine Zwischenschicht aus einem haftvermittelnden Aminoalkyl-alkoxysilan aufgebracht wird.

In der DE-A 3 045 979 (= US-A 4 342 820) ist die Kombination einer speziellen o-Chinondiazidschicht mit einer Silikongummischicht beschrieben. Zur Verbesserung der Haftung zwischen diesen Schichten können einer dieser Schichten Silikone oder Silane zugesetzt werden, oder es kann eine Haftschicht aus solchen Verbindungen zwischen diesen Schichten aufgebracht werden.

In der EP-A 100 938 wird ein Verfahren zur Verbesserung der Haftung entsprechender Schichten durch kurzes Anbelichten und Behandeln mit einer Base, z. B. einem primären Amin, beschrieben. Es kann auch zusätzlich eine Zwischenschicht aus Aminosilanen und bzw. oder Organotitanaten aufgebracht werden.

In der EP-A 154 980 wird eine ähnliche vorsensibilisierte Druckplatte beschrieben, die in der lichtempfindlichen o-Chinondiazidschicht zusätzlich eine Kupplungskomponente enthält, die im basischen Medium, z. B. bei der Entwicklung, mit der unzersetzten Diazoverbindung in den unbelichteten Bereichen zu einem schwerlöslichen Azofarbstoff kuppelt. Während der Kupplungsreaktion tritt zugleich eine verstärkte Verankerung der Silikonschicht auf der Chinondiazidschicht ein. Zusätzlich kann noch eine Haftschicht zwischen diesen Schichten, z. B. aus Aminosilanen oder Organotitanverbindungen, vorgesehen sein.

In der DE-A 23 50 211 wird u. a. eine Druckplatte mit einer lichtvernetzbaren Schicht, einer Silikonhaftschicht und einer farbabweisenden Silikongummischicht beschrieben.

In den DE-A 23 57 871 und 23 59 102 werden Druckplatten für den wasserlosen Offsetdruck beschrieben, bei denen einer Einkomponentensilikonkautschukschicht zur Verbesserung der Haftung auf einer Photopolymer- oder Diazoniumsalz-Polykondensatschicht ein Überschuß an Silan zugesetzt wird.

Haftschichten oder die Haftung verbessernde Zusätze werden, wie der Stand der Technik zeigt, bei positiv und negativ arbeitenden lichtempfindlichen Schichten in Verbindung mit Silikonkautschukschichten verwendet. Sie sind insbesondere bei positiv arbeitenden, d. h. durch Belichten löslich werdenden Schichten erforderlich, da hier keine zusätzliche Verankerung der Bildteile der Schicht durch eine Lichthärtung bzw. -vernetzung erfolgt.

Als haftvermittelnde Verbindungen werden bevorzugt niedermolekulare siliciumorganische Verbindungen, insbesondere Silane, eingesetzt. Die Dämpfe dieser Verbindungen sind gesundheitsschädlich und müssen bei der Herstellung der Platten sorgfältig beseitigt werden. In vielen Fällen ist die mit diesen Verbindungen erzielte Haftverbesserung noch nicht ausreichend. Das gilt vor allem für die Haftung auf Schichten, die durch Belichten löslich werden.

Gegenstand der gleichzeitig eingereichten Patentanmeldung P 36 28 720.2 (Hoe 86/K035) ist eine vorsensibilisierte Druckplatte für den wasserlosen Flachdruck mit einem Schichtträger, einer durch Belichtung löslich werdenden strahlungsempfindlichen Schicht, einer äußeren, Druckfarbe abweisenden vernetzten Silikonkautschukschicht und einer Zwischenschicht, die die Haftung der Silikonkautschukschicht auf der strahlungsempfindlichen Schicht verbessert, die dadurch gekennzeichnet ist, daß die strahlungsempfindliche Schicht als wesentliche Bestandteile

    a) eine Verbindung mit mindestens einer durch Säure spaltbaren C-O-C-Bindung,

    b) eine bei Bestrahlung eine starke Säure bildende Verbindung und

    c) ein in Wasser unlösliches Bindemittel

enthält und die Zwischenschicht aus amorpher Kieselsäure besteht.

Aufgabe der Erfindung war es, eine Druckplatte für den wasserlosen Flachdruck vorzuschlagen, die auf einem Schichtträger eine lichtempfindliche Schicht und darüber eine Druckfarbe abweisende vernetzte Silikonkautschukschicht trägt, die mit der lichtempfindlichen Schicht durch eine Haftschicht verbunden ist, die keine physiologisch und ökologisch bedenklichen Bestandteile enthält, die in einfacher Weise durch Beschichtung aus wäßrigen Lösungen aufgebracht werden kann und die eine besonders gute Verankerung der farbabweisenden auf der lichtempfindlichen Schicht bewirkt.

Gegenstand der Erfindung ist eine vorsensibilisierte Druckplatte für den wasserlosen Flachdruck mit einem Schichtträger, einer strahlungsempfindlichen Schicht, ausgenommen eine Schicht auf Basis eines Gemischs aus einer Verbindung mit mindestens einer durch Säure spaltbaren C-O-C-Bindung und aus einer bei Bestrahlung eine starke Säure bildenden Verbindung, einer äußeren, Druckfarbe abweisenden vernetzten Silikonkautschukschicht und einer Zwischenschicht, die die Haftung der Silikonkautschukschicht auf der strahlungsempfindlichen Schicht verbessert.

Die erfindungsgemäße Druckplatte ist dadurch gekennzeichnet, daß die Zwischenschicht aus amorpher Kieselsäure besteht.

Erfindungsgemäß wird ferner ein Verfahren zur Herstellung einer Druckform für den wasserlosen Flachdruck vorgeschlagen.

Das erfindungsgemäße Verfahren ist dadurch gekennzeichnet, daß man eine vorsensibilisierte Flachdruckplatte der vorstehend beschriebenen Beschaffenheit bildmäßig belichtet, in eine Entwicklerlösung eintaucht und danach an den Nichtbildstellen die lichtempfindliche Schicht zusammen mit der darüberliegenden Silikongummischicht durch Reiben entfernt.

Die in den erfindungsgemäßen Druckplatten enthaltene Zwischenschicht wird vorzugsweise durch Aufbringen eines verdünnten wäßrigen Kieselsäuresols auf die strahlungs-, insbesondere lichtempfindliche Schicht und Trocknen des Sols erzeugt.

Ohne Anwendung dieser Haftschicht weisen Silikongummischichten auf den meisten lichtempfindlichen Schichten eine völlig unzureichende Haftung auf. Wie gefunden wurde, ergeben die sonst üblichen Haftschichten aus Silanen, z. B. Aminoalkylsilanen, zwar eine gewisse Verbesserung der Haftung gegenüber der lichtempfindlichen Schicht. Sie stören jedoch die Verarbeitung der damit hergestellten Druckplatte, oder die Verankerung ist so schlecht, daß sich die Platte nach bildmäßiger Belichtung nicht zu einer brauchbaren Druckschablone entwickeln läßt.

Die zur Herstellung der Haftschichten verwendeten Kieselsäuresole enthalten im allgemeinen Kieselsäurepartikel einer Größe von 5 bis 150, vorzugsweise von 20 bis 50 nm. Geeignet sind sowohl alkalisch als auch sauer, vorzugsweise aber alkalisch stabilisierte wäßrige Kieselsäuresole. Zur besseren Benetzung der lichtempfindlichen Schicht wird dem Sol vorteilhaft eine kleine Menge eines wasserlöslichen Netzmittels, insbesondere eines anionischen oder nichtionischen Netzmittels zugesetzt. Geeignet sind z. B. Alkalisalze von langkettigen Alkansäuren, Alkylsulfonsäuren, Monoalkylsulfaten, Alkylbenzolsulfonsäuren und Polyalkoxyphenolether. Da die Netzmittel selbst einer guten Haftung entgegenwirken, sollte vorzugsweise die Menge an Netzmittel möglichst niedrig gehalten werden. Im allgemeinen werden Mengen von 1 bis 15, vorzugsweise 1 bis 10 und insbesondere 1 bis 5 Gew.-%, bezogen auf den Feststoffgehalt des Sols, eingesetzt.

Die Verankerung der Kieselsäureschicht auf der lichtempfindlichen Schicht kann durch thermisch vernetzende Stoffe, z. B. Dimethylolharnstoff oder wasserlösliche Melaminharze, verstärkt werden. Die Substanzen werden dem verdünnten wäßrigen Kieselsäuresol zugesetzt. Man verwendet etwa 1 bis 100, vorzugsweise 5 bis 20 Gew.-%, bezogen auf die Kieselsäuremenge.

Eine besonders gute Verankerung der Kieselsäureschicht auf der lichtempfindlichen Schicht erreicht man, wenn das Kieselsäuresol etwas in die lichtempfindliche Schicht eindiffundieren kann. Da die Eindringtiefe bei zunehmendem Trocknungsgrad der lichtempfindlichen Schicht zurückgeht, ist es ratsam, die Haftschicht auf möglichst schwach getrocknete Schichten aufzutragen. Die Diffusion kann zudem durch Beimischen wassermischbarer Lösemittel, die die lichtempfindliche Schicht anquellen, zum Kieselsäuresol gesteuert werden. Die Art und Menge des Lösemittels ist dabei so zu wählen, daß die lichtempfindliche Schicht nicht abgelöst wird. Auch eine Vergrößerung der Oberfläche der lichtempfindlichen Schicht durch mechanisches Aufrauhen oder durch Pigmentierung führt zu verstärkter Haftung der Kieselsäureschicht.

Außer den erforderlichen Netz- und eventuell wassermischbaren Lösemitteln können die Kieselsäuresole auch noch feinteilige Füllstoffe enthalten.

Das Schichtgewicht der Kieselsäureschicht kann in weiten Grenzen schwanken, etwa zwischen 0,01 und

1,0 g/m$^2$. Es liegt vorzugsweise zwischen 0,1 und 0,3 g/m$^2$.

Die strahlungsempfindlichen Schichten der erfindungsgemäßen Druckplatten sind als solche bekannt. Sie sind vorzugsweise gegen aktinisches Licht, vor allem langwelliges UV-Licht oder kurzwelliges sichtbares Licht, empfindlich, können aber auch gegen Strahlung im mittleren und kurzwelligen UV-Bereich, Röntgen- oder Korpuskularstrahlung sowie längerwelliges sichtbares Licht empfindlich sein. Sie können negativ oder positiv arbeiten, d. h. durch Bestrahlung unlöslich oder löslich werden. Wegen der durch den wasserlosen Offsetdruck bedingten Bildumkehr drucken Platten mit an sich negativ arbeitenden, lichthärtbaren Schichten positive Bilder der Vorlage und umgekehrt. Bevorzugt haben die erfindungsgemäßen Druckplatten positiv arbeitende, d. h. durch Belichten löslich werdende Schichten, da sich bei dieser Art Schichten die Haftverbesserung durch die Kieselsäureschicht besonders stark auswirkt. Unter diesen Schichten sind diejenigen ausgenommen, die die oben genannten säurespaltbaren Systeme enthalten, da Druckplatten mit diesen Schichten in der dort genannten gleichzeitig eingereichten Patentanmeldung beschrieben und beansprucht werden.

Als durch Belichten löslich werdende Schichten sind insbesondere solche auf Basis von 1,2-Chinondiaziden geeignet. 1,2-Chinondiazide sind bekannt und z. B. in den DE-C 938 233 und 1 543 721, den DE-A 23 31 377, 25 47 905 und 28 28 037 beschrieben. Als 1,2-Chinondiazide werden bevorzugt 1,2-Naphthochinon-2-diazid-4-oder -5-sulfonsäureester oder -amide verwendet. Von diesen werden die Ester, insbesondere die der 5-Sulfonsäure, besonders bevorzugt. Die Menge an 1,2-Chinondiazidverbindungen beträgt im allgemeinen 3 bis 50, bevorzugt 7 bis 35 Gew.-%, bezogen auf die nicht-flüchtigen Anteile der Schicht. Weitere Schichtbestandteile sind vor allem wasserunlösliche, in wäßrigalkalischen Lösungen lösliche Bindemittel.

Als alkalilösliche bzw. in Alkali quellbare Bindemittel sind natürliche Harze wie Schellack und Kolophonium und synthetische Harze wie Mischpolymerisate aus Styrol und Maleinsäureanhydrid sowie insbesondere Novolake zu nennen. Als Novolak-Kondensationsharze haben sich besonders die höher kondensierten Harze mit substituierten Phenolen als Formaldehyd-Kondensationspartner bewährt. Die Art und Menge der alkalilöslichen Harze kann je nach Anwendungszweck verschieden sein; bevorzugt sind Anteile am Gesamtfeststoff zwischen 30 und 90, besonders bevorzugt 55 - 85 Gew.-%. Statt oder im Gemisch mit Novolaken sind vorteilhaft auch Phenolharze vom Typ des Poly(4-vinyl-phenols) verwendbar. Zusätzlich können noch andere Harze mitverwendet werden, die nicht alkalilöslich oder aber wasserlöslich sind. Der günstigste Anteil an diesen Harzen beträgt im allgemeinen nicht mehr als 20% vom alkalilöslichen Harz. In geringen Mengen kann die lichtempfindliche Schicht außerdem Substanzen wie Polyglykole, Cellulosederivate wie Ethylcellulose, Netzmittel, Farbstoffe und feinteilige Pigmente sowie bei Bedarf UV-Absorber enthalten.

Andere geeignete positiv arbeitende Schichten sind solche aus Kombinationen von Diazoniumsalzen und Phenolharzen oder aus Diazoharzen in Form ihrer Fällungsprodukte mit Phosphorwolframsäure.

Als negativ arbeitende Schichten sind u. a. solche aus photopolymerisierbaren Gemischen, lichtvernetzbaren Polymeren, Diazoniumsalz-Polykondensationsprodukten und Azidoverbindungen geeignet.

Geeignete photopolymerisierbare Gemische enthalten eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Die Photoinitiatoren werden im allgemeinen in einer Menge von 0,01 bis 10, bevorzugt von 0,2 bis 5 Gew.-%, bezogen auf die nichtflüchtigen Bestandteile der photopolymerisierbaren Schicht, zugesetzt.

Für die Zwecke der Erfindung geeignete photopolymerisierbare Monomere sind bekannt und z. B. in den US-A 2 760 863 und 3 060 023 beschrieben. Bevorzugte Beispiele sind Acryl- und Methacrylsäureester, wie Polyethylenglykoldimethacrylat, Acrylate und Methacrylate von Trimethylolethan, Trimethylolpropan und Pentaerythrit und von mehrwertigen alicyclischen Alkoholen. Der Mengenanteil der Schicht an Monomeren beträgt im allgemeinen etwa 10 bis 80, vorzugsweise 20 bis 60 Gew.-%.

Als Bindemittel sind z. B. Acrylharze, Polyvinylacetale, Polyvinylester, Maleinatharze, Polymerisate aus N-(p-Tolyl-sulfonyl)-carbaminsäure-(ß-methacryloyloxy-ethyl)ester und Mischpolymerisate dieser und ähnlicher Monomerer mit anderen Monomeren sowie Styrol-Maleinsäureanhydrid-Mischpolymerisate, Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., geeignet. Die Menge des Bindemittels beträgt im allgemeinen 20 bis 90, vorzugsweise 40 bis 80 Gew.-% der Bestandteile der Schicht.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähi-

4

gen Verbindungen, insbesondere aromatischen Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der US-A 3 867 147 beschrieben. Allgemein sind alle Diazoniumsalz-Polykondensationsprodukte geeignet, die in der US-A 4 186 017 beschrieben sind.

Die lichtempfindlichen Schichten mit Diazoniumsalz-Kondensationsprodukten können außerdem Bindemittel, Farbstoffe, Indikatoren, Pigmente, Stabilisatoren, Netzmittel und weitere übliche Zusätze enthalten. Mit Vorteil werden wasserunlösliche harzartige Bindemittel, insbesondere in Kombination mit den bevorzugten Mischkondensationsprodukten von Diazoniumsalzen, verwendet. Beispiele für geeignete Bindemittel sind Polyalkylacrylate, Polyvinylacetale und Umsetzungsprodukte von Dicarbonsäureanhydriden, z. B. Malein- oder Phthalsäureanhydrid, mit OH-Gruppen enthaltenden Polymeren, wie Polyvinylacetalen, Polyvinylalkoholen oder teilverseiften Polyvinylacetaten.

Als lichtvernetzbare Verbindungen sind ferner Polyvinylcinnamate, Chalkonderivate und aromatische Azide geeignet. Auch negativ arbeitende Schichten auf Basis von säurehärtbaren Harzen in Kombination mit Verbindungen, die bei Belichtung Säure bilden, können eingesetzt werden.

Das Gewicht der lichtempfindlichen Schicht liegt im allgemeinen bei 0,3 bis 10 g/m$^2$, Schichtgewichte von etwa 0,8 bis 3 g/m$^2$ werden in den meisten Fällen bevorzugt.

Die Silikonkautschukschicht wird aus einer Lösung in einem unpolaren Lösungsmittel, z. B. aliphatischen oder aromatischen Kohlenwasserstoffen, aufgebracht, in dem sich die Bestandteile der Haftschicht und der lichtempfindlichen Schicht unter den Beschichtungsbedingungen praktisch nicht auflösen.

Grundsätzlich ist jeder Silikonkautschuk geeignet, der ausreichend farbabweisend ist, um ein Drucken im Offsetdruck ohne Feuchtwasser zu erlauben. Als "Silikonkautschuk" soll im Rahmen dieser Erfindung entsprechend der Definition von Noll, "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird. In jedem Fall wird eine Silikonkautschuklösung auf die vorbeschichtete lichtempfindliche Schicht aufgebracht, getrocknet und dann vernetzt.

Als Silikonkautschuke sind Einkomponenten- und Mehrkomponententypen geeignet, wie sie z. B. in den DE-A 23 50 211, 23 57 871 und 23 59 102 beschrieben sind. Die Einkomponenten-Silikonkautschuke basieren auf Polysiloxanen, die z. B. endständige Acetyl-, Oxim-, Alkoxy- oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden bei Raumtemperatur aus (RTV-1-Silikonkautschuke).

Die Mehrkomponenten-Silikonkautschuke können durch Addition oder durch Kondensation vernetzbar sein. Die additionsvernetzbaren Typen enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50° C vernetzt. Sie haben den Vorteil, daß sie bei höherer Temperatur, z. B. um 100 C, schnell vernetzen. Dafür kann auch die Verarbeitungsdauer (Topfzeit) dieser Systeme relativ kurz sein.

Die durch Kondensation vernetzbaren Gemische enthalten Diorganopolysiloxane mit reaktionsfähigen Endgruppen, z. B. OH- und Acetoxygruppen. Diese werden mit reaktiven Silanen oder Oligosiloxanen, z. B. Alkoxy- oder Acetoxysilanen oder Siloxanen, die mehrere Si-H-Gruppen im Molekül enthalten, in Gegenwart von Katalysatoren, wie Organozinnverbindungen, z. B. Dialkylzinndiacetat, vernetzt. Auch diese Kombinationen reagieren relativ schnell und haben deshalb eine begrenzte Topfzeit.

Mit besonderem Vorteil werden durch Kondensation vernetzbare Mehrkomponenten-Silikonkautschuke eingesetzt. Bevorzugte Vernetzer sind Vinyl-triacetoxy-silan und Aminosilane, z. B. Aminoethylaminopropyl-trimethoxy-silan. Mit ihnen erhält man die beste Haftung auf der Kieselsäureschicht und damit auf der lichtempfindlichen Schicht. Mit Aminosilanen vernetzte Schichten lassen sich etwas schwieriger entwickeln als mit Vinyl-triacetoxy-silan vernetzte. Vinyl-triacetoxy-silan kann auch in Kombination mit anderen Vernetzern verwendet werden, solange diese nicht die Solubilisationsreaktion in der lichtempfindlichen Schicht stören. Ausreichende Haftung in Abwesenheit von Alkyl-triacetoxy-silanen erhält man auch mit H-haltigen Siloxanen. Da die Haftung in den ersten Tagen nach Herstellung der Druck-platten noch deutlich zunimmt, sollten aber solche Platten erst nach mehrtägiger Lagerung verarbeitet werden.

Die ausgezeichnete Haftung von Silikongummischichten, die Alkenyl- oder Alkyl-triacetoxy-silane als Vernetzer enthalten, hängt vermutlich mit der Freisetzung von Essigsäure während der Vernetzung des Polysiloxans zusammen. Essigsäure scheint die Reaktion zwischen der Kieselsäurehaftschicht und den Komponenten der Silikongummischicht zu begünstigen. Diese Annahme wird gestützt durch die Beobachtung, daß die mäßige Haftung von Silikongummischichten, die nur acetoxygruppenfreie Vernetzer enthalten, durch Zugabe von Eisessig zur Beschichtungslösung merklich verbessert wird.

Die Konzentration des Vernetzers oder des Vernetzer-Gemisches beträgt üblicherweise 1 - 40 % der Polysiloxanmenge, vorzugsweise 2 - 15 %. Die Katalysatormenge liegt vorzugsweise bei etwa 2 bis 10 Gew.-% des Polysiloxananteils.

Die Silikonkautschuke werden nach dem Aufbringen als Schicht in bekannter Weise durch Feuchtigkeitseinwirkung oder aus sich heraus bei Raumtemperatur oder erhöhter Temperatur zu einem in organischen Lösungsmittel im wesentlichen unlöslichen Silikongummi vernetzt. Die fertige Silikongummischicht hat im allgemeinen ein Gewicht von 1 bis 20, bevorzugt von 2 bis 6 g/m$^2$.

Die dehäsive Silikongummischicht verankert sich vermutlich durch eine chemische Reaktion auf der Kieselsäureschicht. Es wird angenommen, daß eine Kondensationsreaktion eintritt zwischen den an der Oberfläche der Kieselsäureteilchen liegenden Hydroxylgruppen und den Hydroxylgruppen der hochmolekularen unvernetzten Silikonkautschuke.

Die bevorzugten Mehrkomponenten-Silikonkautschuke haben den Vorteil, daß damit hergestellte Druckplatten beim Drucken ohne Feuchtwasser eine wesentlich geringere Neigung zum Tonen aufweisen als solche, die mit normalen Einkomponenten-Silikonkautschuken hergestellt worden sind. Auch die Kratzfestigkeit der Oberfläche des gehärteten Silikongummis ist bei den bevorzugten Verbindungstypen erhöht.

Als Schichtträger werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruckplatten, nicht erforderlich ist, daß die Trägeroberfläche hydrophil ist, können mit Vorteil auch Kupfer, Messing oder andere oleophile Metalle als Trägeroberfläche dienen. Die Trägeroberfläche kann auch eine dauerhafte oleophile Beschichtung tragen, z. B. eine Haftvermittlerschicht. Ferner können Kunststofffolien, wie Polyester-, Polycarbonat-, Polyimid- oder auch Celluloseacetatfolien verwendet werden, deren Oberfläche ggf. zur Erhöhung der Benetzbarkeit durch Druckfarbe aufgerauht oder anderweitig vorbehandelt sein kann. Weiterhin sind bekannte Druckplattenträger aus Papier geeignet, das hier nicht unbedingt naßfest zu sein braucht. Auch gummielastische Trägermaterialien sind geeignet; mit solchen Trägern kann auch im direkten Flachdruck gedruckt werden.

Das Trägermaterial dient bei den Druckformen, die aus dem erfindungsgemäßen Material hergestellt werden, im Gegensatz zu sonst üblichen Druckformen, als farbführendes Material. Die nach dem Belichten und Entwickeln stehengebliebene Silikongummischicht dient als Bildhintergrund und wirkt in trockenem Zustand farbabstoßend. Zum Druck können dabei sowohl übliche Druckfarben auf Ölbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt, z. B. Druckfarben, wie sie in der DE-C 3 140 360 beschrieben sind.

Die Herstellung der erfindungsgemäßen Druckplatten erfolgt in bekannter Weise. Der Druckplattenträger wird zunächst mit der lichtempfindlichen Beschichtungslösung wie üblich beschichtet. Man trocknet die Schicht nur schwach und trägt dann das netzmittelhaltige verdünnte Kieselsäuresol an. Auf die getrocknete Kieselsäureschicht trägt man schließlich die Polysiloxanlösung auf, die ggf. Vernetzer und Katalysatoren enthält, trocknet und vernetzt die Schicht durch mehrstündiges Lagern bei Raumtemperatur (RTV-1-Kautschuk) oder durch mäßiges Erwärmen, z. B. 1 Minute lang bei 100 bis 120° C, und zusätzliche mehrstündige Lagerung im Dunkeln bei Raumtemperatur (RTV-2-Kautschuk).

Aus dem vorsensibilisierten Material erhält man eine druckfertige Flachdruckform durch Belichten unter einer Filmvorlage und durch Entwickeln. Zur Belichtung eignen sich z. B. Quecksilberlampen, Kohlenbogenlampen, Metallhalogenidlampen, Xenon-Lampen, Leuchtröhrengeräte, Lasergeräte, Elektronenstrahlröhren und andere bekannte Belichtungsgeräte. Beim Entwicklungsvorgang wird die abhäsive Silikongummischicht von der Entwicklerlösung angequollen, und die leichter löslichen Partien der strahlungsempfindlichen Schicht werden darin aufgelöst. Beim Abreiben mit einem weichen Material, z. B. Watte, Textilien oder Schaumgummi, brechen die über den gelösten Stellen der Schicht liegenden Bereiche der gequollenen Silikongummischicht aus. Dabei wird die Oberfläche des Druckplattenträgers freigelegt. Die freigelegte Oberfläche nimmt Druckfarbe leicht an, während die erhalten gebliebene Silikonschicht die Farbe abstößt. Das Einfärben der entwickelten Platte kann in oder außerhalb der Druckmaschine erfolgen.

Brauchbare Entwickler müssen sowohl die Abhäsivschicht stark aufquellen und rasch durchdringen, als auch die löslichen Bereiche der lichtempfindlichen Schicht gut entwickeln. Dabei dürfen die schwerlöslichen Bereiche nicht angegriffen werden. Als Entwickler werden bekannte Lösemittelgemische, z. B. Gemische aus aliphatischen Kohlenwasserstoffen und Alkoholen oder Ketonen eingesetzt.

Die beim Entwickeln freigelegte, farbführende Trägeroberfläche liegt wenige Mikrometer tiefer als die farbabstoßenden Nichtbildbereiche. Die Vertiefungen können durch Aufwalzen von Druckfarbe ausgefüllt werden. Nach Trocknen der Farbe liegen die farbannehmenden und farbabstoßenden Bereiche auf gleicher Ebene.

Die Erfindung wird im einzelnen anhand der nachfolgenden Beispiele erläutert. Gewichtsteile (Gt) und Volumteile (Vt) stehen im Verhältnis von g/ml. Mengenverhältnisse und Prozentangaben sind, wenn nichts anderes vermerkt ist, in Gewichtseinheiten zu verstehen.

Beispiel 1

Auf eine durch Bürsten aufgerauhte Aluminiumplatte wurde eine filtrierte Lösung von

| | |
|---|---|
| 1,8 Gt | des unten beschriebenen Naphthochinondiazid-sulfonsäureesters, |
| 0,22 Gt | Naphthochinon-(1,2)-diazid-(2)-4-sulfonylchlorid, |
| 0,07 Gt | 2,3,4-Trihydroxy-benzophenon, |
| 6,6 Gt | eines Kresol-Formaldehyd-Novolaks mit einem Schmelzbereich von 105 - 120°C nach DIN 53181 und |
| 0,08 Gt | Kristallviolett in |
| 91,22 Gt | eines Gemischs aus 5 Vt Tetrahydrofuran, 4 Vt Ethylenglykolmonomethylether und 1 Vt Butylacetat |

aufgebracht und getrocknet.

Der in der obigen Rezeptur verwendete Naphthochinondia-zidsulfonsäureester wurde wie folgt hergestellt:

Eine Lösung von 25,5 Gt Naphthochinon-(1,2)-diazid-(2)-5-sulfonsäurechlorid in 442 Gt Aceton wurde über Aktivkohle geklärt. In der Lösung wurden 26,3 Gt des oben angegebenen Kresol-Formaldehyd-Novolaks und 4,4 Gt 2,3,4-Tri-hydroxy-benzophenon gelöst und das Ganze mit einer Lösung von 11,9 Gt $NaHCO_3$ in 124 Gt Wasser und mit 160 Gt gesättigter Natriumchloridlösung versetzt. Das Gemisch wurde 10 Minuten gerührt, absitzen gelassen, die untere Phase verworfen und die Acetonlösung innerhalb weniger Minuten in eine Lösung aus 6 Gt HCl (30 %) und 1500 Gt Wasser einfließen gelassen. Das ausgeschiedene gelbe flockige Reaktionsprodukt wurde abgesaugt, mit Wasser ausgewaschen und getrocknet. Die Ausbeute betrug 48 Gt.

Auf das erhaltene lichtempfindliche Material wurde die folgende Lösung aufgeschleudert:

| | |
|---|---|
| 95,2 Gt | entsalztes Wasser, |
| 4,8 Gt | 30 %iges anionisches Kieselsäuresol mit einem $Na_2O$-Gehalt von ca. 0,15 % und einer Teilchengröße von 25 - 30 nm. |
| 0,04 Gt | Nonylphenol-polyglykolether. |

Der Teller der Plattenschleuder hatte dabei eine Drehzahl von etwa 175 U/Minute. Nach Trocknen der Schicht mit Warmluft wurde - bei ca. 110 U/Minute - nachstehende Lösung aufgeschleudert:

| | |
|---|---|
| 84 Gt | aliphatisches Kohlenwasserstoffgemisch, Siedebereich 116 - 142°C, |
| 15 Gt | einer 33 %igen Lösung eines Dihydroxypolydimethylsiloxans in Toluol, Viskosität bei 25°C = 9.000 bis 15.000 mPa•s, |
| 0,7 Gt | Vinyl-triacetoxysilan, |
| 0,3 Gt | Dibutylzinndiacetat. |

Die Schicht wurde getrocknet und durch 4-minütiges Erwärmen im Trockenschrank auf 110°C vulkanisiert. Das Gewicht der Dehäsivschicht betrug 3,3 g/m².

Die so gewonnene vorsensibilisierte Druckplatte wurde unter einer Negativ-Filmvorlage (48er Raster) 40

EP 0 257 504 B1

s mit einer 5 kW-Metallhalogenid-Lampe im Abstand von 120 cm belichtet und danach einige Minuten mit einem mit Entwicklerflüssigkeit getränkten Wattebausch abgerieben. Dabei lösten sich alle drei Schichten an den belichteten Stellen ab. Der verwendete Entwickler bestand aus 4 Volumteilen Isopropanol und 1 Volumteil aliphatischem Kohlenwasserstoffgemisch (Siedebereich 116-142°C).

In einer Kleinoffsetdruckmaschine, aus der das Feuchtwerk entfernt worden war, ließ sich die Druckform mit handelsüblicher Waterless-Offset-Druckfarbe (Waterless Normal Schwarz 175 845 der Sicpa Druckfarben GmbH) leicht einfärben. Beim Drucken lieferte sie saubere Abzüge. Nach 10.000 Drucken zeigte das Druckbild noch keine Beschädigungen.

Bei direktem Auftrag der angegebenen Silikonkautschuklösung auf eine gleiche Positiv-Druckplatte ohne Haftschicht zeigte die vernetzte Silikongummischicht nur ungenügende Haftung. Beim Entwicklungsprozeß wurde die Dehäsivschicht teilweise auch in den unbelichteten Bereichen abgelöst, das Bild also stark beschädigt.

Beispiele 2 bis 11

Beispiel 1 wurde wiederholt; anstelle von 0,7 g Vinyltriacetoxy-silan wurden aber die in Tabelle 1 angegebenen Vernetzer oder Vernetzergemische eingesetzt:

## Tabelle 1

| Beispiel Nr. | Vinyl-tri-acetoxy-silan (Gt) | Gt | zweites Silan |
|---|---|---|---|
| 2 | 0,40 | - | - |
| 3 | 1,00 | - | - |
| 4 | 0,47 | 0,23 | Vinyl-triethoxy-silan |
| 5 | 0,35 | 0,35 | " |
| 6 | 0,23 | 0,47 | " |
| 7 | 0,35 | 0,35 | Tetraethoxy-silan |
| 8 | 0,35 | 0,35 | 3-Glycidyloxy-propyl-tri-methoxy-silan |
| 9 | 0,35 | 0,35 | Methylhydrogensiloxan/Dimethylsiloxan/Trimethyl-siloxan 72/24/4 (Molverhältnis) mit 1,36 % Si-gebundenem H (Mischpolym.) |
| 10 | 0,35 | 0,35 | N-Aminoethyl-aminopropyl-trimethoxy-silan |
| 11 | - | 0,55 | " |

In allen Fällen ließen sich gute Druckplatten herstellen, die saubere Abzüge lieferten.

Ohne die erfindungsgemäße, aus Kieselsol gewonnene Zwischenschicht hafteten die Silikonschichten der Beispiele 2 bis 11 schlecht auf der Positivschicht. Die Druckplatte nach Beispiel 11 benötigte eine etwas längere Entwicklungszeit.

Beispiel 12

Eine Positivdruckplatte wurde wie in Beispiel 1 lichtempfindlich beschichtet und durch Aufschleudern

8

folgender Lösung mit einer Haftschicht versehen:

| | |
|---|---|
| 5,5 Gt | Kieselsäuresol mit einem $SiO_2$-Gehalt von 49,5 % und einem $Na_2O$-Gehalt von 0,21 % und einer Teilchengröße von 21-24 nm, |
| 0,04 Gt | Nonylphenol-polyglykolether, |
| 94,5 Gt | entsalztes Wasser. |

Die haftvermittelte Platte wurde wie in Beispiel 1 mit einer Silikonkautschukschicht überzogen, druckfertig gemacht und zum Drucken verwendet. Sie lieferte saubere Drucke.

Beispiel 13

Eine elektrolytisch aufgerauhte und anodisierte Aluminiumplatte wurde mit einer Lösung von

| | |
|---|---|
| 1,2 Gt | des Veresterungsproduktes aus 1 mol 2,3,4-Trihydroxy-benzophenon und 2 mol Naphthochinon-(1,2)-diazid-(2)-5-sulfonsäurechlorid, |
| 0,7 Gt | des Veresterungsproduktes aus 1 mol 2,2'-Dihydroxy-dinaphthyl-(1,1')-methan und 2 mol Naphthochinon-(1,2)-diazid(2)-5-sulfonsäurechlorid, |
| 6,5 Gt | des in Beispiel 1 angegebenen Novolaks und |
| 0,05 Gt | Sudangelb GGN (C.I. 11021) |

in einem Lösungsmittelgemisch aus

| | |
|---|---|
| 40 Gt | 2-Methoxy-ethanol, |
| 50 Gt | Tetrahydrofuran und |
| 8 Gt | Butylacetat |

beschichtet und getrocknet. Auf die lichtempfindliche Schicht wurden dann, wie in Beispiel 1 beschrieben, nacheinander eine Kieselsäurehaftschicht und eine Silikonkautschukschicht aufgebracht. Die erhaltene Druckplatte wurde unter einer Negativvorlage belichtet, mit einem Gemisch aus 7 Teilen Isopropanol und 3 Teilen aliphatischem Kohlenwasserstoffgemisch (Siedebereich 116-142°C) entwickelt und in einer Offsetdruckmaschine ohne Feuchtung verdruckt. Es wurden saubere, scharfe Drucke erhalten. Eine in gleicher Weise, aber ohne Haftschicht hergestellte Druckform ergab keine brauchbaren Drucke.

Beispiele 14 bis 16

Die in Tabelle 2 aufgeführten handelsüblichen Offsetdruckplatten mit Positivschicht wurden wie in Beispiel 13 mit einer Haftschicht und einer Silikon-gummischicht versehen, belichtet, mit einem Gemisch von Isopropanol und aliphatischem Kohlenwasserstoffgemisch (4:1) entwickelt und ohne Feuchtung verdruckt. Alle Formen lieferten saubere scharfe Abzüge. Bei Abwesenheit der Haftschicht konnte mit keiner der verwendeten Positivplatten eine brauchbare Negativtrockenoffsetform gewonnen werden.

## Tabelle 2

| Beispiel Nr. | Druckplatte | Hersteller |
|---|---|---|
| 14 | Spartan[R] | Howson-Algraphy |
| 15 | GP II | Polychrome |
| 16 | Endura[R] P | 3 M |

Beispiel 17

Mit einer Lösung von

| 0,88 Gt | 4-($\alpha,\alpha$-Dimethyl-benzyl)-phenylester der Naphthochinon-(1,2)-diazid-(2)-4-sulfonsäure, |
|---|---|
| 0,44 Gt | des Veresterungsproduktes aus einem mol 2,2'-Dihydroxy-dinaphthyl-(1,1))-methan und 2 mol Naphthochinon-(1,2)-diazid-(2)-5-sulfonsäurechlorid, |
| 5,90 Gt | des in Beispiel 1 angegebenen Novolaks, |
| 0,20 Gt | Naphthochinon-(1,2)-diazid-(2)-4-sulfonsäurechlorid und |
| 0,06 Gt | Kristallviolett |

in einem Lösungsmittelgemisch aus

| 40 Gt | 2-Methoxy-ethanol, |
|---|---|
| 40 Gt | Tetrahydrofuran und |
| 8 Gt | Butylacetat |

wurde eine elektrochemisch aufgerauhte und anodisierte Aluminium-Folie beschichtet. Die erhaltene Druckplatte wurde mit folgender Lösung schleuderbeschichtet (175 U/Minute):

| 4,0 Vt | Kieselsäuresol wie in Beispiel 1, |
|---|---|
| 4,0 Vt | einer 1 %igen Lösung von Nonylphenolpolyglykolether in Wasser, |
| 15 Vt | Isopropanol, |
| 77 Vt | entsalztes Wasser. |

Nach Trocknung der Haftschicht wurde die Platte nach den Angaben von Beispiel 1 mit einer Silikongummischicht überzogen. Die getrocknete Offsetdruckplatte wurde mit einer 5 kW-Metallhalogenidlampe 2 Minuten durch eine Negativfilmvorlage belichtet und dann durch Abreiben mit einem entwicklergetränkten Wattebausch entwickelt. Als Entwickler diente ein 1:1-Gemisch aus Isopropanol und aliphatischem Kohlenwasserstoff (Siedebereich 116-142 °C).

Die Form lieferte auf einer Kleinoffset-Druckmaschine ohne Feuchtwerk gute saubere Drucke.

Bei Abwesenheit der Kieselsäurehaftschicht war die Herstellung einer Trockenoffsetdruckform infolge ungenügender Haftung der Silikongummischicht nicht möglich.

Beispiel 18

Eine Lösung von

| | |
|---|---|
| 5 Gt | des unten beschriebenen Diazoniumsalz-Polykondensationsprodukts, |
| 0,5 Gt | Phosphorsäure (85 %) und |
| 0,5 Gt | Victoriareinblau FGA (C.I. 42595) in |
| 95 Gt | 2-Methoxy-ethanol |

wurde auf eine Aluminiumplatte aufgebracht, die zuvor elektrolytisch aufgerauht, anodisiert und mit einer wäßrigen Polyvinylphosphonsäurelösung vorbehandelt worden war.

Das Polykondensationsprodukt wurde wie folgt erhalten:

In 170 Gt 85 %iger Phosphorsäure wurden 32,4 Gt 3-Methoxy-diphenylamin-4-diazoniumsulfat gelöst. In diese Lösung tropfte man 22,8 Gt 4-Methyl-4'-methoxymethyldiphenylether und kondensierte 2 Stunden bei 40°C. Danach wurden 25,8 Gt 4,4'-Bis-methoxymethyl-diphenylether zu dem Gemisch hinzugefügt und weitere 27 Stunden bei 40°C kondensiert. Das Rohkondensat löste man in 5000 Vt Wasser. Die Abscheidung des Kondensats erfolgte mit 500 Vt gesättigter Kochsalzlösung. Das Chlorid des Kondensats wurde in 800 Vt Wasser gelöst und hieraus mit 300 Vt gesättigter Natriummethansulfonat-Lösung das Methansulfonat ausgefällt. Der Niederschlag wurde nach dem Absaugen in Wasser gelöst und mit Natriummesitylensulfonat-Lösung als Mesitylensulfonat wieder ausgefällt. Es wurden 59 Gt Kondensat erhalten.

Die oben beschriebene Druckplatte wurde wie in Beispiel 1 mit Kieselsäure und Silikonkautschuk beschichtet. Die erhaltene Platte wurde unter einer Positivfilmvorlage 1 Minute mit einer 5 kW Metallhalogenidlampe im Abstand von 120 cm belichtet, die unbelichteten Bezirke dann mit der folgenden Entwicklerlösung abgelöst:

| | |
|---|---|
| 50 Gt | Propylenglykolmonomethylether, |
| 7,5 Gt | 2-Hydroxy-ethylacetat, |
| 7,5 Gt | 2-Acetyloxy-ethylacetat, |
| 0,5 Gt | 1,3-Dioxolan-2-on, |
| 1 Gt | Ammoniumbenzoat und |
| 10 Gt | Glycerin in |
| 23,5 Gt | Wasser. |

Die erhaltene Druckform war für den wasserlosen Offsetdruck geeignet.

Bei Abwesenheit der Kieselsäurezwischenschicht haftete die Silikongummischicht deutlich schlechter auf der lichtempfindlichen Schicht.

Beispiel 19

Auf eine elektrolytisch aufgerauhte und anodisch oxydierte Aluminiumplatte wurde die folgende Beschich-tungslösung aufgebracht und getrocknet:

| | |
|---|---|
| 97 Gt | des Umsetzungsprodukts von Polyvinylbutyral (MG 70.000; 71 % Vinylbutyral-, 2 % Vinylacetat-, 27 % Vinylalkoholeinheiten) mit Propenylsulfonylisocyanat (Säurezahl 81), |
| 48 Gt | eines Diazoniumsalz-Polykondensationsprodukts aus 1 mol 3-Methoxy-diphenylamin-4-diazoniumsulfat und 1 mol 4,4'-Bis-methoxymethyldiphenylether, isoliert als Mesitylensulfonat, |
| 4,8 Gt | Phosphorsäure (85 %), |
| 3,5 Gt | Victoriareinblau FGA (C.I. Basic Blue 81) und |
| 1,6 Gt | Phenylazodiphenylamin in |
| 3500 Gt | 2-Methoxy-ethanol und |
| 1036 Gt | Tetrahydrofuran. |

Auf die erhaltene lichtempfindliche Schicht wurden, wie in Beispiel 1 beschrieben, eine Kieselsäure-Haftschicht und eine Silikongummischicht aufgebracht. Die Platte wurde dann unter einer Positivvorlage 40 Sekunden wie in Beispiel 18 belichtet und mit einem Gemisch aus 70 % eines aliphatischen Kohlenwasserstoffgemischs (Siede-bereich 174-189° C) und 30 % Propylenglykolmonomethylether entwickelt. Die erhaltene Druckform verhielt sich ähnlich wie die von Beispiel 18.

Beispiel 20

Eine handelsübliche Negativdruckplatte auf Basis von Diazoverbindungen (Marathon[R]AQ2; Hersteller: Howson-Algraphy) wurde wie in Beispiel 1 beschrieben mit einer Haftschicht und einer Silikongummischicht versehen, 45 Sekunden wie in Beispiel 18 belichtet und mit einem Gemisch von Isopropanol und dem in Beispiel 1 angegebenen Kohlenwasserstoffgemisch (1:1) entwickelt. Die Ergebnisse waren praktisch die gleichen wie in Beispiel 18.

Beispiel 21

Eine unter der Bezeichnung WRN im Handel befindliche Negativoffsetdruckplatte auf Photopolymerbasis (Hersteller: Polychrome) wurde mit folgender Kieselsäuresollösung beschichtet:

| | |
|---|---|
| 4 Vt | Kieselsäuresol wie in Beispiel 1, |
| 4 Vt | einer 1 %igen Lösung von Nonylphenolpolyglykolether in Wasser, |
| 42 Vt | entsalztes Wasser, |
| 50 Vt | Isopropanol. |

Nach Trocknung der Haftschicht wurde die Platte nach den Angaben von Beispiel 1 mit einer Silikongummischicht überzogen und durch 25 s Belichten mit einer 5 kW Metallhalogenidlampe unter einer Positivfilmvorlage (Schrift-/Strichmuster) und durch nachfolgendes Abreiben mit einem entwicklerfeuchten Wattebausch in eine druckfertige Platte für den wasserlosen Offsetdruck überführt. Als Entwickler diente ein Gemisch aus 9 Vt aliphatischem KW-Gemisch mit dem Siedebereich 174-189° C und 1 Vt Propylenglykolmonomethylether.

Auf einer Kleinoffset-Druckmaschine ohne Feuchtwerk wurden mit der Form saubere Drucke erzielt.
Ohne die Kieselsäurehaftschicht konnte keine brauchbare Trockenoffsetdruckform gewonnen werden.

Beispiel 22

Eine Negativoffsetdruckplatte auf Photopolymerbasis mit der Bezeichnung S-GAN (Hersteller: Polychrome) wurde mit dem folgenden Kieselsäuresol schleuderbeschichtet:

| | |
|---|---|
| 4 Vt | Kieselsäuresol wie in Beispiel 1, |
| 4 Vt | einer 1 %igen Lösung von Nonylphenolpolyglykolether in Wasser, |
| 0,1 Gt | Dimethylolharnstoff, |
| 92 Gt | entsalztes Wasser. |

Die Weiterverarbeitung erfolgte nach den Angaben von Beispiel 1, die Negativfilmvorlage wurde lediglich gegen eine Positivfilmvorlage ausgetauscht. Während der Belichtung wurde darauf geachtet, daß die Filmvorlage die gesamte Oberfläche der Form bedeckte.
Es resultierte eine Druckform, die gut für den wasserlosen Offsetdruck geeignet war.
Ohne die Haftschicht gelang die Herstellung einer brauchbaren Trockenoffsetdruckform nicht.

Beispiel 23

Eine entsprechend Beispiel 1 mit Kieselsäurehaftschicht versehene Positivdruckplatte wurde mit folgender Silikonkautschuklösung schleuderbeschichtet (110 U/min):

| 15 Gt | einer 30 %igen Lösung eines vinylgruppenhaltigen Polysiloxans in Toluol mit einer Viskosität (25° C) von 15.000 bis 30.000 mPa•s, |
|---|---|
| 0,5 Gt | einer 5 %igen Lösung eines Methylhydrogensiloxan/Dimethylsiloxan/TrimethylsiloxanMischpolymerisates (Molverhältnis 72/24/4) mit 1,36 % an Si gebundenem Wasserstoff in Benzin, |
| 0,5 Gt | einer Katalysatorlösung mit einem Platingehalt von 0,1 %, |
| 0,2 Gt | Vinyl-triacetoxy-silan, |
| 84 Gt | eines aliphatischen Kohlenwasserstoffgemischs, Siedebereich 116-142° C. |

Die Kautschukschicht wurde durch 4 Minuten Erwärmen auf 110° C zum Silikongummi vulkanisiert und dann nach Bei-spiel 1 weiterverarbeitet. Als Entwickler diente ein mit Natriummetasilikat gesättigtes trübes Gemisch aus 90 Vt Wasser, 9 Vt Isopropanol und 1 Vt aliphatischem Kohlenwasserstoffgemisch, Siedebereich 116-142° C.

Die gewonnene Trockenoffsetform lieferte sehr saubere Drucke.

In Abwesenheit der Kieselsäure-Zwischenschicht haftete die Silikongummischicht so schlecht, daß die Herstellung von Druckformen nicht möglich war.

Beispiel 24

Beispiel 1 wurde wiederholt, anstelle der angegebenen Silikonkautschuklösung aber folgende Mischung verwendet:

| 16,9 Gt | einer 75 %igen Lösung eines füllstoffhaltigen Einkomponenten-Silikonkautschuks vom Amin-Typ in Toluol mit einer Viskosität (25° C) von ca. 9 Pa•s, |
|---|---|
| 135,0 Gt | aliphatisches Kohlenwasserstoffgemisch, Siedebereich 116-142° C, |
| 5,6 Gt | Toluol. |

Zur Vulkanisation wurde die Schicht nicht erwärmt, sondern einen Tag lang an der Luft (im Dunkeln) liegen gelassen.

Bei Verwendung der hergestellten Druckform in einer Klein-Offsetdruckmaschine, aus der das Feuchtwerk entfernt worden war, zeigte die farbabstoßende Silikongummischicht gute Haftung und Haltbarkeit. Ohne die erfindungsgemäße Kieselsäurehaftschicht wurde die Silikongummischicht beim Ablösen der belichteten Bereiche beschädigt.

Beispiel 25

Beispiel 1 wurde mit folgender Silikonkautschuklösung wiederholt:

| 11,4 Gt | der in Beispiel 1 angegebenen Dimethylpolysiloxanollösung, |
|---|---|
| 9,4 Gt | einer 40 %igen toluolischen Lösung eines füllstoffhaltigen Einkomponentensilikonkautschuks vom Essigsäuretyp mit einer Viskosität von ca. 350 mPa•s (25° C), |
| 0,53 Gt | Vinyl-triacetoxy-silan, |
| 0,22 Gt | Dibutylzinndiacetat, |
| 100 Gt | aliphatisches Kohlenwasserstoffgemisch, Siedebereich 116-142° C. |

Auf der Druckmaschine wurden saubere Drucke erhalten. Ähnlich gute Ergebnisse wurden erhalten, wenn als Druckfarbe die folgende hydrophile Dispersion verwendet wurde:

40 Gt einer wäßrigen Emulsion eines alkalilöslichen Acrylatpolymerisats mit einem Festkörpergehalt von 40 Gew.-%, 20 Gt Propylenglykol, 4 Gt Triethanolamin, 4 Gt einer 35 %igen Methylsilikonölemulsion, 4 Gt Mineralöl mit einem Siedebereich von 190-250 C und 8 Gt Stärkeether wurden miteinander gemischt.

Dieser Mischung wurden 20 Gt eines wäßrigen Pigmentteiges mit einem Gehalt von 45 Gew.-% Kupferphthalocyaninpigment zugefügt. Die Masse wurde auf einer Dreiwalze zu einer homogenen Druckfarbe dispergiert.

**Patentansprüche**

EP 0 257 504 B1

1. Vorsensibilisierte Druckplatte für den wasserlosen Flachdruck mit einem Schichtträger, einer strahlungsempfindlichen Schicht, ausgenommen eine Schicht auf Basis eines Gemischs aus einer Verbindung mit mindestens einer durch Säure spaltbaren C-O-C-Bindung und aus einer bei Bestrahlung eine starke Säure bildenden Verbindung, einer äußeren, Druckfarbe abweisenden vernetzten Silikonkautschukschicht und einer Zwischenschicht, die die Haftung der Silikonkautschukschicht auf der strahlungsempfindlichen Schicht verbessert, dadurch gekennzeichnet, daß die Zwischenschicht aus amorpher Kieselsäure besteht.

2. Druckplatte nach Anspruch 1, dadurch gekennzeichnet, daß die Zwischenschicht durch Auftragen und Trocknen eines wäßrigen Kieselsäuresols erhalten worden ist.

3. Druckplatte nach Anspruch 2, dadurch gekennzeichnet, daß das Kieselsäuresol ein wasserlösliches Netz-mittel enthält.

4. Druckplatte nach Anspruch 2, dadurch gekennzeichnet, daß das Kieselsäuresol eine Teilchengröße von 5 bis 150 nm hat.

5. Druckplatte nach Anspruch 1, dadurch gekennzeichnet, daß die Zwischenschicht ein Flächengewicht von 0,01 bis 1 g/m$^2$ hat.

6. Druckplatte nach Anspruch 1, dadurch gekennzeichnet, daß der Silikonkautschuk ein bei Raumtemperatur vernetzbarer Zweikomponentenkautschuk ist.

7. Druckplatte nach Anspruch 6, dadurch gekennzeichnet, daß der Silikonkautschuk als Vernetzer ein Alkenyl-triacetoxy-silan enthält.

8. Druckplatte nach Anspruch 1, dadurch gekennzeichnet, daß die Silikonkautschukschicht ein Flächengewicht von 1 bis 20 g/m$^2$ hat.

9. Druckplatte nach Anspruch 1, dadurch gekennzeichnet, daß die strahlungsempfindliche Schicht als strahlungsempfindliche Verbindung ein 1,2-Chinondiaziid enthält.

10. Druckplatte nach Anspruch 1, dadurch gekennzeichnet, daß die strahlungsempfindliche Schicht eine lichthärtbare Schicht ist.

11. Verfahren zur Herstellung einer Druckform für den wasserlosen Flachdruck, dadurch gekennzeichnet, daß man eine vorsensibilisierte Flachdruckplatte gemäß Anspruch 1 bildmäßig belichtet, in eine Entwicklerlösung eintaucht und danach an den Nichtbildstellen die lichtempfindliche Schicht zusammen mit der darüberliegenden Silikongummischicht durch Reiben entfernt.

## Claims

1. A presensitized printing plate for waterless planographic printing, which comprises a layer support, a radiation-sensitive layer, with the exception of a layer based on a mixture of a compound possessing at least one C-O-C bond which can be split by acid and a compound forming a strong acid upon irradiation, an outer, ink-repellent, crosslinked silicone elastomer layer and an intermediate layer by which the adhesion of the silicone elastomer layer to the radiation-sensitive layer is improved, characterized in that the intermediate layer is comprised of amorphous silicic acid.

2. A printing plate as claimed in Claim 1, wherein the intermediate layer is produced by applying and drying an aqueous silicic acid sol.

3. A printing plate as claimed in Claim 2, wherein the silicic acid sol contains a water-soluble surfactant.

4. A printing plate as claimed in Claim 2, wherein the silicic acid sol has a particle size of 5 to 150 nm.

5. A printing plate as claimed in Claim 1, wherein the intermediate layer has a weight per unit area of 0.01

14

EP 0 257 504 B1

g/m$^2$ to 1 g/m$^2$.

6. A printing plate as claimed in Claim 1, wherein the silicone elastomer is a two-component elastomer which can be crosslinked at room temperature.

7. A printing plate as claimed in Claim 6, wherein the silicone elastomer contains an alkenyl-triacetoxysilane as the crosslinking agent.

8. A printing plate as claimed in Claim 1, wherein the silicone rubber layer has a weight per unit area of 1 g/m$^2$ to 20 g/m$^2$.

9. A printing plate as claimed in Claim 1, wherein the radiation-sensitive layer contains a 1,2-quinonediazide as the radiation-sensitive compound.

10. A printing plate as claimed in Claim 1, wherein the radiation-sensitive layer is a photocurable layer.

11. A process for preparing a printing form suitable for waterless planographic printing, wherein a presensitized planographic printing plate as claimed in Claim 1 is imagewise exposed and then immersed into a developer solution and thereafter the photosensitive layer is removed from the non-image areas by rubbing, together with the portions of the silicone rubber layer, which are present over these areas.

**Revendications**

1. Plaque d'impression présensibilisée pour la lithographie à sec, comprenant un support de couche, une couche radiosensible, à l'exception d'une couche à base d'un mélange d'un composé comportant au moins une liaison C-O-C clivable par un acide et d'un composé formant un acide fort par irradiation, une couche externe d'élastomère de silicone réticulé imperméable à l'encre d'imprimerie, et une couche intermédiaire qui améliore l'adhérence de la couche d'élastomère de silicone à la couche radiosensible, caractérisée en ce que la couche intermédiaire se compose d'acide silicique amorphe.

2. Plaque d'impression selon la revendication 1, caractérisée en ce que la couche intermédiaire est obtenue par dépôt et séchage d'un sol d'acide silicique aqueux.

3. Plaque d'impression selon la revendication 2, caractérisée en ce que le sol d'acide silicique contient un mouillant hydrosoluble.

4. Plaque d'impression selon la revendication 2, caractérisée en ce que la taille des particules du sol d'acide silicique est comprise entre 5 et 150 nm.

5. Plaque d'impression selon la revendication 1, caractérisée en ce que la couche intermédiaire présente un poids sur facique de 0,01 à 1 g/m$^2$.

6. Plaque d'impression selon la revendication 1, caractérisée en ce que l'élastomère de silicone est un élastomère à deux composants, réticulable à température ambiante.

7. Plaque d'impression selon la revendication 6, caractérisée en ce que l'élastomère de silicone contient, comme agent réticulant, un alcényl-triacétoxysilane.

8. Plaque d'impression selon la revendication 1, caractérisée en ce que la couche d'élastomère de silicone présente un poids surfacique de 1 à 20 g/m$^2$.

9. Plaque d'impression selon la revendication 1, caractérisée en ce que la couche radiosensible contient, comme composé radiosensible, un 1,2-quinonediazide.

10. Plaque d'impression selon la revendication 1, caractérisée en ce que la couche radiosensible est une couche photodurcissable.

15

**11.** Procédé de fabrication d'un support d'impression pour la lithographie à sec, caractérisé en ce qu'on expose à la lumière, selon l'image, une plaque d'impression lithographique présensibilisée, telle que revendiquée dans la revendication 1, on la plonge dans une solution développatrice et on élimine ensuite par frottement, des zones de non-image, la couche photosensible ainsi que la couche de caoutchouc de silicone placée dessus.